# FASCICULE DE BREVET EUROPEEN

(11) **EP 1 183 777 B1**
(45) Date de publication et mention de la délivrance du brevet: **30.07.2003**
(21) Numéro de dépôt: 00936952.1
(22) Date de dépôt: 26.05.2000
(51) Int. Cl.: H03H 19/00

(54) **FILTRE PASSE-BANDE A REDUCTION DE LA FREQUENCE PORTEUSE**
BANDPASSFILTER MIT VERRINGERUNG DER TRÄGERFREQUENZ
BAND-PASS FILTER WITH CARRIER FREQUENCY REDUCTION

(30) Priorité: 27.05.1999 FR 9906710
(43) Date de publication de la demande: 06.03.2002
(73) Titulaire: FRANCE TELECOM, 75015 Paris (FR)
(72) Inventeur: MORCHE, Dominique, F-38240 Meylan (FR)
(74) Mandataire: Texier, Christian
(86) Numéro de dépôt international: FR0001448
(87) Numéro de publication internationale: WO00074236

(56) Documents cités:
- EP-A- 0 743 749
- WO-A-94/29948
- GB-A- 2 052 196
- US-A- 4 653 117
- D. MORCHE ET AL: "A High Q 200 MHz Low-Power Fully Integrated Bandpass IF Filter" IEEE 1998 CUSTOM INTEGRATED CIRCUITS CONFERENCE, 11 - 14 mai 1998, pages 401-404, XP002137785 New York, US cité dans la demande

## Description

L'invention concerne les filtres analogiques passe-bande et plus particulièrement ceux présentant une force sélectivité à des fréquences élevées, typiquement quelques centaines de MHz.

L'invention concerne ainsi notamment les architectures d'extrémité avant (ou « front end » en anglais) de récepteurs ou d'émetteurs de signaux radiofréquences

Une des applications de l'invention concerne l'intégration d'une partie analogique d'un récepteur de terminal mobile de type GSM, l'objectif de cette partie analogique étant d'amplifier le signal reçu par les antennes à une fréquence très élevée, de sélectionner une bande de fréquences qui intéresse l'utilisateur du terminal, et de ramener cette bande de fréquence à une fréquence faible.

De manière connue, la sélection d'une bande de fréquence se fait par filtrage. Le filtrage intégré habituel ne permet pas d'obtenir des coefficients de qualité élevée. Pour sélectionner une bande étroite qui correspond à la bande de fréquence d'un utilisateur, il faut donc en général soit utiliser un filtre externe (connu sous le nom de « SAW ») ou diminuer la fréquence porteuse du signal.

Une telle opération de diminution de la fréquence porteuse, appelée transposition de fréquence, se fait généralement à l'aide de multiplieurs analogiques. L'un des problèmes majeurs de cette transposition de fréquences est la formation d'une fréquence image qui vient s'ajouter au signal désiré. Pour cette raison, il n'est pas simple avec les dispositifs connus de diminuer la fréquence sans l'utilisation d'un filtre extérieur (notamment un filtre SAW) qui vient éliminer la fréquence image.

Pour réaliser un filtrage étroit d'un canal situé à haute fréquence, on a proposé dans la demande de brevet FR 95 05847, un montage tel que celui représenté à la figure 1 dans lequel on effectue sur deux branches parallèles à chaque fois une transposition de fréquence d'un même signal d'entrée à filtrer, puis un filtrage passe-bas, puis à nouveau une transposition de fréquence jusqu'à la fréquence originale du signal d'entrée. Pour éviter le repliement de la fréquence image dans le canal utile, on utilise pour les quatre transpositions réalisées, deux signaux seulement qui sont en quadrature de phase et ces deux signaux sont chacun envoyés sur chacune des deux branches selon un croisement permettant de compenser d'éventuels écarts de déphasage.

On propose également dans ce document d'utiliser un déphaseur RC-CR tel que celui représenté à la figure 2, qui garantit la quadrature entre les deux signaux. Toutefois, lorsque la fréquence d'un oscillateur placé en entrée du déphaseur est légèrement différente de la fréquence de coupure du déphaseur, les deux signaux de sortie ne sont pas d'amplitude égale.

Ce phénomène est compensé dans ce dispositif de l'art antérieur par le croisement des signaux en quadrature à l'intérieur du montage.

On a également proposé dans « A High Q200 MHz Low - Power Fully Integreted Bandpass IF filter » CICC'98, un tel croisement des signaux en quadrature à l'intérieur d'une structure d'un filtre passe-bande.

Ces dispositifs, s'ils permettent de réaliser un filtrage à une fréquence très élevée, ne permettent pas par contre de diminuer (dans le cas d'un récepteur) ou d'augmenter (dans le cas d'un émetteur) la fréquence porteuse du signal, bien qu'il mette en oeuvre quatre multiplieurs.

Le but de l'invention est de proposer un procédé et un dispositif pour le filtrage étroit d'un signal de fréquences élevées qui permettent également de diminuer la fréquence porteuse de ce signal tout en faisant appel à un faible nombre de multiplieurs.

Ce résultat est obtenu avec un dispositif de filtrage passe-bande tel que défini par la revendication 2.

L'invention propose également pour atteindre ce but un procédé de filtrage passe-bande dans lequel on effectue en parallèle deux transpositions de fréquence d'un signal d'entrée à filtrer à l'aide respectivement d'un premier signal de mélange amont et d'un deuxième signal de mélange amont sensiblement en quadrature de phase, de façon à obtenir respectivement des premiers et deuxième signaux transposés, et on filtre respectivement les deux signaux transposés par deux filtres passe-bas, la fréquence de ces signaux de transposition et les bandes passantes des filtres passe-bas étant reliées à la fréquence du signal d'entrée et à la bande passante souhaitée pour le filtre passe-bande, puis on effectue des transpositions de fréquence respectives sur le premier signal transposé filtré et le deuxième signal transposé filtré à l'aide de deux signaux de mélange aval respectifs, et on effectue la différence ou la somme des deux signaux ainsi obtenus, la fréquence des signaux de mélange de sortie étant choisie différente de la fréquence des premiers et deuxièmes signaux de mélange de telle façon que le signal de sortie se trouve transposé dans un intervalle de fréquence souhaité, caractérisé en ce qu'on utilise un même oscillateur couplé avec un premier déphaseur pour produire les signaux de mélange amont et couplé avec un deuxième déphaseur pour produire les signaux de mélange aval, et en ce que l'on utilise les déphaseurs de manière opposée sur les premier et deuxième signaux de façon à ce que chacun des premier et deuxième signaux reçoive de l'un des deux déphaseurs le signal de sortie en avance de phase de celui-ci, et de l'autre des deux déphaseurs le signal de sortie en retard de phase de celui-ci.

D'autres caractéristiques, buts et avantages de l'invention apparaîtront à la lecture de la description détaillée qui va suivre, faite en référencs aux dessins annexés sur lesquels :
- la figure 1 représente le circuit conforme à l'état de la technique précédemment mentionne ;
- la figure 2 représente le circuit RC-CR conforme à l'état de la technique précédemment mentionné ;
- la figure 3 est un schéma de montage d'un circuit conforme à l'invention ;
- la figure 4 est un schéma de montage d'un déphaseur amont du circuit de la figure 3 ;
- la figure 5 est un schéma de montage d'un déphaseur aval du circuit de la figure 3.

Un dispositif préféré de filtrage passe-bande selon l'invention est un dispositif comprenant deux voies parallèles de traitement disposées entre l'entrée et la sortie du dispositif, comportant chacune une cellule de filtrage passe-bas disposée entre un mélangeur amont et un mélangeur aval, et des moyens de transposition délivrant aux mélangeurs amont deux signaux de mélange amont respectifs sensiblement en quadrature de phase et aux mélangeurs aval deux signaux de mélange aval respectifs sensiblement en quadrature de phase, et comportant un additionneur ou un soustracteur connecté aux sorties des mélangeurs aval, les moyens de transposition étant prévus pour délivrer des signaux de mélange avals de fréquence choisie différente de la fréquence des signaux de mélange amont de telle façon que le signal de sortie du filtre passe-bande se trouve transposé dans un intervalle de fréquence souhaité, le dispositif comportant un même oscillateur couplé avec un premier déphaseur pour produire les signaux de mélange amont et couplé avec un deuxième déphaseur pour produire les signaux de mélange aval, et en ce que les déphaseurs sont placés de manière opposée de façon à ce que chacune des deux branches parallèles reçoive de l'un des deux déphaseurs le signal de sortie en avance de phase de celui-ci, et de l'autre des deux déphaseurs le signal de sortie en retard de phase de celui-ci.

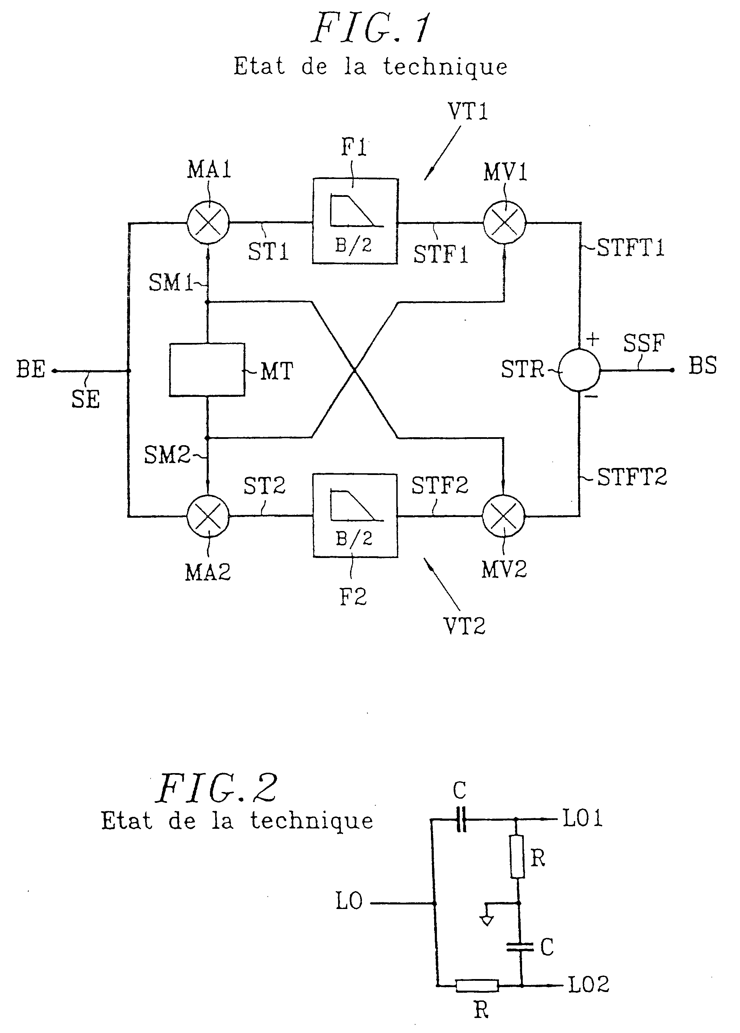

Tel qu'illustré sur la figure 1, le filtre passe-bande de l'art antérieur. dont la largeur de la bande passante est égale à B, comporte une borne d'entrée BE pour recevoir un signal d'entrée SE de pulsation ωₑ, et deux voies de traitement parallèles VT1 et VT2. Chaque voie de traitement comporte un mélangeur amont MA1 (MA2) suivi d'un filtre passe-bas F1 (F2) connecté à un mélangeur aval MV1(MV2). Les sorties respectives des mélangeurs aval sont reliées aux deux entrées d'un soustracteur STR dont la sortie est reliée à la borne de sortie BS du filtre.

Il est par ailleurs prévu des moyens de transposition MT délivrant deux signaux de mélange SM1 et SM2 de pulsation ω₀, sensiblement en quadrature de phase. Le premier signal de mélange SM1 est délivré au mélangeur amont MA1 et le signal transposé résultant ST1 donne, après filtrage dans le filtre F1, un signal transposé filtré STF1 qui, après transposition dans le mélangeur aval MV1 à l'aide du deuxième signal de mélange SM2, fournit un signal retransposé STFT1 à l'une des entrées du soustracteur STR.

De même, le deuxième signal de mélange SM2 est délivré au mélangeur amont MA2 de façon à permettre l'obtention du signal transposé ST2 et, après filtrage, du signal transposé filtré STF2. Ce signal STF2 donne, après transposition dans le mélangeur aval MV2 à l'aide du premier signal SM1, le signal retransposé STFT2 délivré à l'autre entrée du soustracteur STR.

Après différence des deux signaux STFT1 et STFT2, le signal de sortie SSF est débarrassé de la bande latérale indésirable centrée sur la pulsation 2 ω₀ -ωₑ, ce qui équivaut à éliminer l'influence du signal image du signal d'entrée.

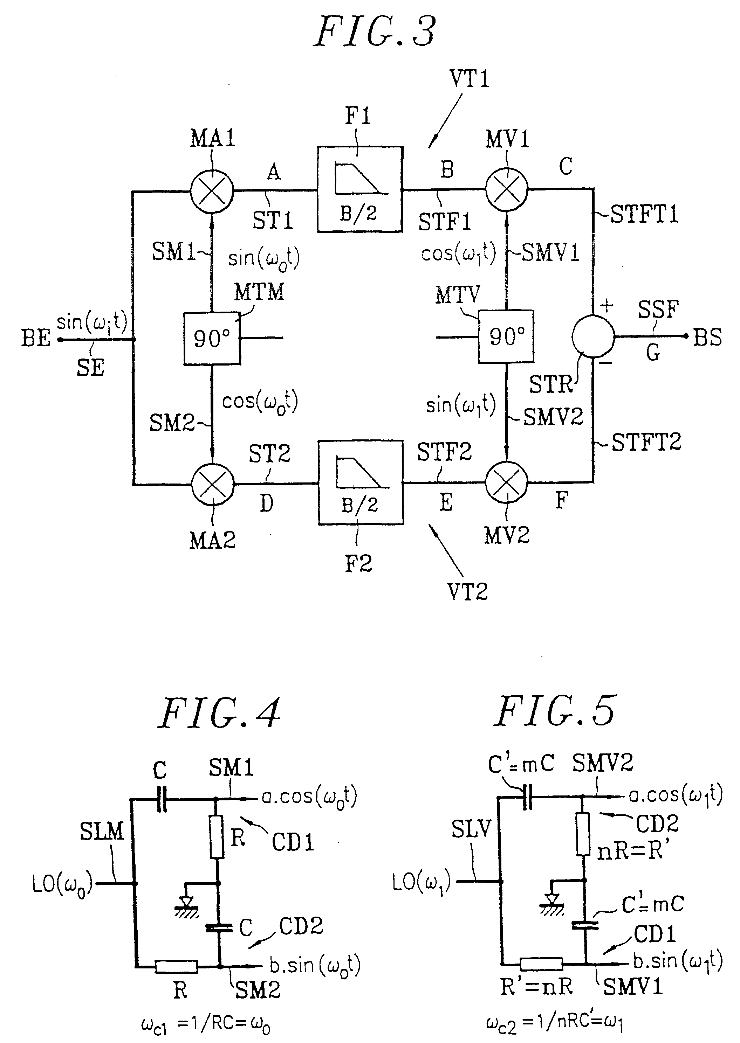

Comme illustré sur la figure 3, le filtre passe-bande selon l'invention reprend une structure générale à deux voies de traitement parallèles VT1 et VT2, comportant chacune un mélangeur amont MA1 (MA2) suivi d'un filtre passe bas F1 (F2) connecté à un mélangeur aval MV1 (MV2).

Les sorties respectives des mélangeurs aval sont reliées aux deux entrées d'un soustracteur STR dont la sortie est reliée à la borne de sortie BS du filtre. Dans ce dispositif également, les deux mélangeurs amont reçoivent des signaux de transposition en quadrature de phase SM1 et SM2, et les deux mélangeurs aval MV1 et MV2 reçoivent également deux signaux de transposition en quadrature de phase.

Si l'on suppose, à des fins de simplification, que les signaux de mélange délivrés aux mélangeurs MA1 et MA2 sont respectivement de la forme sin (ω₀t) et cos (ω₀t), et que le signal d'entrée SE a pour pulsation ωᵢ, les signaux présents en sortie de ces mélangeurs présentent une première bande de fréquence centrée autour de la pulsation (ωᵢ - ω₀) (et une deuxième bande de fréquence centrée autour de la pulsation (ωᵢ + ω₀), éliminée par les filtres passe-bas F1 et F2).

ω₀ est donc choisi, en commun avec la largeur B/2 du filtre passe-bas F1, F2 de façon à ce que la relation B >2 |ω₀-ωᵢ| soit vérifiée.

En d'autres termes, ω₀ est choisi de manière à réaliser une transposition de fréquence adaptée à la bande de fréquence utile que l'on souhaite filtrer, la limite supérieure B dépendant de la sélectivité souhaitée.

i En sortie des filtres passe-bas F1 et F2, les signaux des deux branches sont alors soumis à une transposition de fréquences par multiplication avec des signaux oscillant à la pulsation ω₁.

Les deux signaux de transposition appliqués sur les mélangeurs amont présentent une pulsation ω₀ différente de la pulsation ω₁ des deux signaux de transposition appliqués sur les mélangeurs aval.

Les signaux obtenus en sortie des mélangeurs aval sur chacune des deux branches présentent alors une première bande de fréquence centrée autour de la pulsation (-ωᵢ+ω₀+ω₁) et une deuxième bande de fréquence centrée autour de la pulsation( ωᵢ -ω₀ + ω₁).

Les signaux SMV1 et SMV2 injectés respectivement sur les mélangeurs aval MV1 et MV2, étant en quadrature de phase, ainsi que les signaux SM1 et SM2 injectés sur les mélangeurs MA1 et MA2, une composante de chaque signal arrivant sur l'une des deux entrées du soustracteur STR s'annule avec la composante correspondante du signal arrivant sur l'autre entrée du soustracteur. Celle restante des deux composantes du signal s'additionne à la composante restante de l'autre signal. Ainsi, une seule bande fréquentielle est obtenue en sortie du soustracteur STR, ici celle centrée sur la pulsation (ωᵢ - ω₀ + ω₁).

Par un choix judicieux de ω₁, on obtient donc une bande de fréquence centrée sur une fréquence de travail souhaitée.

Pour fournir les signaux en quadrature SM1 et SM2 et les signaux en quadrature SMV1 et SMV2, on propose dans le présent mode de réalisation de disposer en entrée des mélangeurs amont un ensemble formé d'un oscillateur LO à la fréquence ω₀ associé à un déphaseur MTM de type RC-CR, représenté à la figure 4. Ce déphaseur MTM se compose de deux cellules de déphasage CD1 et CD2 disposées respectivement entre la sortie de l'oscillateur local LO et les deux voies de traitement VT1 et VT2.

La première cellule de déphasage CD1 est une cellule capacitive-résistive comportant une capacité C dont une borne est connectée à une sortie de l'oscillateur LO et dont l'autre borne est connectée à la masse par l'intermédiaire d'une résistance R. L'autre cellule de déphasage CD2 est une cellule résistive-capacitive comportant une même résistance R dont une borne est reliée à la sortie de l'oscillateur LO et dont l'autre borne est reliée à la masse par l'intermédiaire d'une capacité C identique à celle de la cellule CD1.

Après passage dans la cellule de déphasage CD1, le signal SL de sortie de l'oscillateur local LO subit un déphasage de (90°-ϕ) (par exemple 45°) défini par le produit R.C de façon à délivrer le premier signal de mélange SM1. La cellule de déphasage CD2 permet, puisque la résistance R est égale à la résistance R de la cellule CD1 et que sa capacité C est égale à la capacité C de la cellule CD1, de délivrer le deuxième signal de mélange SM2 présentant un déphasage égal à - ϕ par rapport au signal de sortie de l'oscillateur LO.

Le déphaseur aval MTV reçoit sur son entrée un signal sinusoïdal à la pulsation ω₁,. Ce signal d'entrée est généré par division de fréquence à partir du signal de sortie à ω₀ de l'oscillateur LO, à l'aide d'un diviseur de fréquence de type connu.

Selon une variante, les deux signaux d'entrée des déphaseurs, respectivement à ω₀ et ω₁, peuvent être tous deux obtenus par division de fréquence sur un signal de sortie d'un oscillateur, les deux rapports de division étant évidemment différents.

Le rapport entre les deux fréquences ω₀ et ω₁ est connu avec précision, et ici égal à un nombre rationnel, c'est à dire à un rapport de nombres entiers.

Le déphaseur aval MTV présente une structure semblable à celle du déphaseur amont MTM, comme on l'a représenté sur la figure 5. Pour ce deuxième déphaseur on adopte deux capacités C' ayant chacune une valeur de capacité mC où m est un nombre entier. Les deux résistances R' de ce déphaseur ont chacune une valeur de résistance égale à nR où n est un entier.

Selon une variante, le rapport m entre C' et C peut être un nombre rationnel, de même que le rapport n entre R' et R.

Les valeurs des résistances et des capacités des circuits MTM et MTV sont choisies de façon à ce que les pulsations de coupure de chacun de ces deux circuits soient égales aux pulsations des signaux qu'ils reçoivent à leurs entrées respectives, de sorte que l'on obtient un même gain sur les deux voies de filtrage VT1 et VT2, dans le cas des deux déphaseurs.

Les résistances et les capacités du deuxième déphaseur MTV présentent donc des valeurs R' et C' choisies de telle façon que le rapport R'C'/RC est égal au rapport ω₀/ω₁ des pulsations des signaux issus de ces deux déphaseurs MTM et MIV. Le rapport ω₀/ω₁ est donc égal à un rapport d'entiers.

Les déphaseurs MTM et MTV sont positionnés de manière opposée de sorte qu'une même branche parallèle VT1 ou VT2 reçoive de l'un des déphaseurs le signal de sortie en avance de phase de ce déphaseur et de l'autre déphaseur la sortie en retard de phase de cet autre déphaseur. A titre de simplification, chacun des déphaseurs fournissant un signal sinus et un signal cosinus, la disposition des déphaseurs est telle qu'une même branche VT1 ou VT2 reçoit de l'un des déphaseurs un signal en sinus et de l'autre des deux déphaseurs un signal en cosinus. Chaque branche est reliée à la cellule R-C d'un des déphaseurs et à la cellule C-R de l'autre déphaseur.

Du fait que les signaux d'entrée des déphaseurs sont fournis à partir d'un même oscillateur L0, en cas de léger décalage d'une des deux fréquences ω₀ ou ω₁, ce décalage se retrouve sur l'autre de ces deux fréquences, et les deux déphaseurs présentent un écart d'amplitude entre leurs deux sorties qui est le même. Les déphaseurs étant en positions inversées, chaque branche reçoit un signal amplifié et un signal alterné, de sorte qu'une compensation des écarts d'amplitude dus à d'éventuelles variations des fréquences des oscillateurs prend place dans chaque branche et cette compensation est effective sur une grande bande de fréquences.

On choisit avantageusement ω ₀ et ω₁ de telle façon que la valeur de ω₀ soit égale à un nombre rationnel multiplié par la valeur de ω₁. Ainsi, le rapport souhaité entre les valeurs des résistances des deux déphaseurs ainsi que le rapport souhaité entre les valeurs des capacités des deux déphaseurs sont des nombres rationnels facilement et précisément obtenus avec les techniques classiques de réalisation des circuits intégrés. De plus, grâce au rapport égal à un nombre rationnel des fréquences de coupure, l'éventuelle différence d'amplitude entre sinus et cosinus sera particulièrement similaire pour les deux déphaseurs (mis à part l'erreur d'appariement des blocs, qui sera limitée puisqu'on a un rapport entier).

Il est également prévu d'adopter pour ces déphaseurs un rapport de pulsations égal à un rapport d'entier et d'adopter des valeurs de résistances ou de capacités en fonction des entiers formant ce rapport On peut choisir C et C' égaux et les résistances R' et R de telle façon que R'/R, c est a dire ω₀/ω₁, soit un nombre entier ou rationnel. De même, on peut choisir R et R' égaux et C et C' de telle façon que C'/C, c'est à dire ω₀/ω₁, soit égal à un nombre entier ou rationnel.

De plus, en réalisant les deux déphaseurs selon à chaque fois une succession d'étapes similaires, un éventuel écart sur la fréquence de coupure ou sur la valeur de déphasage, dû à une imperfection de réalisation, se retrouve de manière similaire sur les deux circuits, de sorte que cet écart est compensé par le croisement des circuits.

L'utilisation de déphaseurs de type RC-CR permet toutefois d'obtenir une bonne précision sur la phase.

L'invention permet donc de faciliter l'intégration complète dans un circuit intégré de la partie analogique du récepteur.

## Revendications

1. Procédé de filtrage passe-bande dans lequel on effectue en parallèle deux transpositions de fréquence d'un signal d'entrée à filtrer (SE) à l'aide respectivement d'un premier signal de mélange (SM1) amont et d'un deuxième signal de mélange (SM2) amont sensiblement en quadrature de phase, de façon à obtenir respectivement des premiers (ST1) et deuxième (ST2) signaux transposés, et on filtre respectivement les deux signaux transposés par deux filtres passe-bas (F1, F2), la fréquence de ces signaux de transposition (ω₀) et les bandes passantes des filtres passe-bas (B/2) étant reliées à la fréquence du signal d'entrée (ωₑ) et à la bande passante souhaitée pour le filtre passe-bande, puis on effectue des transpositions de fréquence respectives sur le premier signal transposé filtré (STF1) et le deuxième signal transposé filtré (STF2) à l'aide de deux signaux de mélange aval respectifs, et on effectue la différence ou la somme des deux signaux ainsi obtenus, la fréquence des signaux de mélange de sortie (SMV1, SMV2) étant choisie différente de la fréquence des premiers et deuxièmes signaux de mélange de telle façon que le signal de sortie se trouve transposé dans un intervalle de fréquence souhaité, **caractérisé en ce qu'**on utilise un même oscillateur (LO) couplé avec un premier déphaseur (MTM) pour produire les signaux de mélange amont et couplé avec un deuxième déphaseur (MTV) pour produire les signaux de mélange aval, et **en ce que** l'on utilise les déphaseurs de manière opposée sur les premier et deuxième signaux de façon à ce que chacun des premier et deuxième signaux (VT1, VT2) reçoive de l'un des deux déphaseurs le signal de sortie en avance de phase de celui-ci, et de l'autre des deux déphaseurs le signal de sortie en retard de phase de celui-ci.

2. Dispositif de filtrage passe-bande comprenant deux voies parallèles de traitement (VT1, VT2) disposées entre l'entrée (BE) et la sortie (BS) du dispositif, comportant chacune une cellule de filtrage passe-bas (F1, F2) disposée entre un mélangeur amont (MA1, MA2) et un mélangeur aval (MV1, MV2), et des moyens de transposition (LO, MTM, MTV) délivrant aux mélangeurs amont (MA1, MA2) deux signaux de mélange amont respectifs sensiblement en quadrature de phase et aux mélangeurs aval (MV1, MV2) deux signaux de mélange aval respectifs sensiblement en quadrature de phase, et comportant un additionneur ou un soustracteur (STM) connecté aux sorties des mélangeurs aval, les moyens de transposition étant prévus pour délivrer des signaux de mélange avals de fréquence choisie (ω₁) différente de la fréquence des signaux de mélange amont (ω₂) de telle façon que le signal de sortie du filtre passe-bande se trouve transposé dans un intervalle de fréquence souhaité, **caractérisé en ce que** qu'il comporte un même oscillateur (LO) couplé avec un premier déphaseur (MTM) pour produire les signaux de mélange amont et couplé avec un deuxième déphaseur (MIV) pour produire les signaux de mélange aval, et **en ce que** les déphaseurs sont placés de manière opposée de façon à ce que chacune des deux branches parallèles (VT1, VT2) reçoive de l'un des deux déphaseurs le signal de sortie en avance de phase de celui-ci, et de l'autre des deux déphaseurs le signal de sortie en retard de phase de celui-ci.

3. Dispositif selon la revendication 2, **caractérisé en ce que** le rapport entre la fréquence des signaux de mélange amont (ω₀) et la fréquence des signaux de mélange aval (ω₁) est égal à un rapport d'entier.

4. Dispositif selon l'une des revendications 2 ou 3, **caractérisé en ce que** les deux déphaseurs sont constitués par des circuits qui présentent chacun une fréquence de coupure entre leurs deux sorties déphasées qui est égale respectivement à la fréquence des signaux de mélange amont (ω₀) pour le premier déphaseur (MTM) et à la fréquence des signaux de mélange aval (ω₁) pour le deuxième déphaseur (MTV).

5. Dispositif selon l'une des revendications 2 à 4, **caractérisé en ce qu'**il comporte un oscillateur (LO) couplé à un premier déphaseur (MTM) formé par un circuit RC-CR pour fournir les signaux de mélange amont, et un oscillateur (LO) couplé à un deuxième déphaseur (MTV) formé d'un deuxième circuit RC-CR pour fournir les signaux de mélange aval.

6. Dispositif selon la revendication 5, **caractérisé en ce que** les condensateurs (C, C') du premier et du deuxième circuit RC-CR présentent une même valeur de capacité et les résistances de ces circuits sont choisies de sorte que le rapport (n) de la valeur des résistances du deuxième circuit RC-CR sur la valeur des résistances du premier circuit RC-CR est égale au rapport (n) de la fréquence des signaux de mélange amont (ω₀) sur la fréquence des signaux de mélange aval (ω₁).

7. Dispositif selon la revendication 5, **caractérisé en ce que** les résistances (R, R') du premier et du deuxième circuit RC-CR présentent une même valeur et les capacités (C, C') de ces circuits sont choisies de sorte que le rapport (m) de la valeur des capacités du deuxième circuit RC-CR sur la valeur des capacités du premier circuit RC-CR est égale au rapport (m) de la fréquence des signaux de mélange amont (ω₀) sur la fréquence des signaux de mélange aval (ω₁).

8. Dispositif selon la revendication 5, **caractérisé en ce que** les condensateurs (C, C') du premier et du deuxième circuit RC-CR présentent des valeurs de capacités dont le rapport est égal à un rapport d'entiers, et **en ce que** les résistances (R, R') du premier et du deuxième circuit RC-CR présentent des valeurs de résistance dont le rapport est égal à un rapport d'entiers.

9. Dispositif selon l'une des revendications 5 à 8, **caractérisé en ce que** les circuits RC-CR sont placés de manière opposée de façon à ce que chacune des deux branches parallèles (VT1, VT2) reçoive de l'un des deux circuits RC-CR le signal de sortie en avance de phase de celui-ci, et de l'autre des deux circuits RC-CR le signal de sortie en retard de phase de celui-ci.

10. Dispositif selon l'une quelconque des revendications 2 à 9, en combinaison avec la revendication 4, **caractérisé en ce que** l'oscillateur (LO) est couplé à un desdits premier et deuxième déphaseurs (MTM, MTV) par l'intermédiaire d'un moyen de transposition de fréquence.

## Patentansprüche

1. Verfahren zum Bandpaßfiltern, bei dem parallel zwei Frequenztranspositionen eines zu filternden Eingangssignals (SE) mit Hilfe jeweils eines ersten stromauf gelegenen Mischsignals (SM1) und eines zweiten stromauf gelegenen Mischsignals (SM2), im wesentlichen in Phasenquadratur, derart durchgeführt werden, daß jeweils erste (ST1) und zweite (ST2) transponierte Signale erhalten werden, und die beiden transponierten Signale mittels zweier Tiefpaß-Filter (F1, F2) jeweils gefiltert werden, wobei die Frequenz dieser Transpositionssignale (ω₀) und die Durchlaßbanden der Tiefpaß-Filter (B/2) mit der Frequenz des Eingangssignals (ωₑ) und der gewünschten Durchlaßbande des Bandpaß-Filters verknüpft sind, anschließend jeweilige Frequenztranspositionen am ersten gefilterten transponierten Signal (STF1) und am zweiten gefilterten transponierten Signal (STF2) mit Hilfe zweier jeweiliger stromab gelegener Mischsignale durchgeführt werden, und die Differenz oder Summe der beiden so erhaltenen Signale gebildet wird, wobei die Frequenz der Ausgangsmischsignale (SMV1, SMV2) unterschiedlich zur Frequenz der ersten und zweiten Mischsignale gewählt wird, derart, daß das Ausgangssignal sich in ein gewünschtes Frequenzintervall transponiert befindet, **dadurch gekennzeichnet, daß** der gleiche Oszillator (LO) verwendet wird, der mit einem ersten Phasenschieber (MTM) gekoppelt ist, um die stromauf gelegenen Mischsignale zu erzeugen, und der mit einem zweiten Phasenschieber (MTV) gekoppelt ist, um die stromab gelegenen Mischsignale zu erzeugen, und daß die Phasenschieber auf entgegengesetzte Weise an den ersten und zweiten Signalen derart angewandt werden, daß jedes der ersten und zweiten Signale (VT1, VT2) von einem der beiden Phasenschieber das Ausgangssignal mit voreilender Phase von diesem und der andere der beiden Phasenschieber das Ausgangssignal mit verzögerter Phase von diesem empfängt.

2. Vorrichtung zum Bandpaßfiltern, die zwei parallele Bearbeitungspfade (VT1, VT2) umfaßt, die zwischen dem Eingang (BE) und dem Ausgang (BS) der Vorrichtung angeordnet sind und von denen jeder eine Tiefpaß-Filterzelle (F1, F2) umfaßt, die zwischen einem stromauf gelegenen Mischer (MA1, MA2) und einem stromab gelegenen Mischer (MV1, MV2) angeordnet sind, und Transpositionsmittel (LO, MTM, MTV), die den stromauf gelegenen Mischern (MA1, MA2) zwei jeweilige stromauf gelegene Mischsignale, im wesentlichen in Phasenquadratur, und den stromab gelegenen Mischern (MV1, MV2) zwei jeweilige stromab gelegene Mischsignale, im wesentlichen in Phasenquadratur, liefern, und die einen Addierer oder einen Substrahierer (STM) umfaßt, der mit den Ausgängen der stromab gelegenen Mischern verbunden ist, wobei die Transpositionsmittel zum Liefern der stromab gelegenen Mischsignale mit einer ausgewählten Frequenz (ω₁) vorgesehen sind, die unterschiedlich zur Frequenz der stromauf gelegenen Mischsignale (ω₂) sind, derart, daß das Ausgangssignal des Bandpaß-Filters sich in ein gewünschtes Frequenzintervall transponiert befindet, **dadurch gekennzeichnet, daß** sie einen gleichen Oszillator (LO) aufweist, der mit einem ersten Phasenschieber (MTM) gekoppelt ist, um die stromauf gelegenen Mischsignale zu erzeugen, und der mit einem zweiten Phasenschieber (MTV) gekoppelt ist, um die stromab gelegenen Mischsignale zu erzeugen, und daß die Phasenschieber auf entgegengesetzte Weise derart angeordnet sind, daß jeder der beiden parallelen Zweige (VT1, VT2) von einem der beiden Phasenschieber das Ausgangssignal mit voreilender Phase von diesem, und vom anderen der beiden Phasenschieber das Ausgangssignal mit verzögerter Phase von diesem empfängt.

3. Vorrichtung nach Anspruch 2, **dadurch gekennzeichnet, daß** das Verhältnis zwischen der Frequenz der stromauf gelegenen Mischsignale (ω₀) und der Frequenz der stromab gelegenen Mischsignale (ω₁) gleich einem ganzzahligen Verhältnis ist.

4. Vorrichtung nach einem der Ansprüche 2 oder 3, **dadurch gekennzeichnet, daß** die beiden Phasenschieber durch Schaltungen verwirklicht sind, die jede eine Trennfrequenz zwischen ihren beiden phasenverschobenen Ausgängen aufweisen, die jeweils gleich der Frequenz der stromauf gelegenen Mischsignale (ω₀) für den ersten Phasenschieber (MTM) und gleich der Frequenz der stromab gelegenen Mischsignale (ω₁) für den zweiten Phasenschieber (MTV) sind.

5. Vorrichtung nach einem der Ansprüche 2 bis 4, **dadurch gekennzeichnet, daß** sie einen Oszillator (LO) aufweist, der mit einem ersten Phasenschieber (MTM) gekoppelt ist, der durch eine RC-CR-Schaltung gebildet ist, um die stromauf gelegenen Mischsignale zu liefern, und einen Oszillator (LO), der mit einem zweiten Phasenschieber (MTV) gekoppelt ist, der aus einer zweiten RC-CR-Schaltung gebildet ist, um die stromab gelegenen Mischsignale zu liefern.

6. Vorrichtung nach Anspruch 5, **dadurch gekennzeichnet, daß** die Kondensatoren (C, C') der ersten und der zweiten RC-CR-Schaltung den gleichen Kapazitätswert aufweisen, und die Widerstände dieser Schaltungen derart gewählt sind, daß das Verhältnis (n) des Wertes der Widerstände der zweiten RC-CR-Schaltung zu dem Wert der Widerstände der ersten RC-CR-Schaltung gleich dem Verhältnis (n) der Frequenz der stromauf gelegenen Mischsignale (ω₀) zur Frequenz der stromab gelegenen Mischsignale (ω₁) ist.

7. Vorrichtung nach Anspruch 5, **dadurch gekennzeichnet, daß** die Widerstände (R, R') der ersten und der zweiten RC-CR-Schaltung den gleichen Wert aufweisen und die Kapazitäten (C, C') dieser Schaltungen derart gewählt sind, daß das Verhältnis (m) des Wertes der Kapazitäten der zweiten RC-CR-Schaltung zum Wert der Kapazitäten der ersten RC-CR-Schaltung gleich dem Verhältnis (m) der Frequenz der stromauf gelegenen Mischsignale (ω₀) zur Frequenz der stromab gelegenen Mischsignale (ω₁) ist.

8. Vorrichtung nach Anspruch 5, **dadurch gekennzeichnet, daß** die Kondensatoren (C, C') der ersten und der zweiten RC-CR-Schaltung Kapazitätswerte aufweisen, deren Verhältnis gleich einem ganzzahligen Verhältnis ist, und daß die Widerstände (R, R') der ersten und der zweiten RC-CR-Schaltung Widerstandswerte aufweisen, deren Verhältnis gleich einem ganzzahligen Verhältnis ist.

9. Vorrichtung nach einem der Ansprüche 5 bis 8, **dadurch gekennzeichnet, daß** die RC-CR-Schaltungen derart auf entgegengesetzte Weise angeordnet sind, daß jeder der beiden parallelen Zweige (VT1, VT2) von einer der RC-CR-Schaltungen das Ausgangssignal mit voreilender Phase von diesem, und von der anderen der beiden RC-CR-Schaltungen das Ausgangssignal mit verzögerter Phase von diesem empfängt.

10. Vorrichtung nach einem der Ansprüche 2 bis 9 in Kombination mit Anspruch 4, **dadurch gekennzeichnet, daß** der Oszillator (LO) mit einem der ersten und zweiten Phasenschieber (MTM, MTV) mittels eines Frequenztranspositionsmittels gekoppelt ist.

## Claims

1. A bandpass filtering method in which two frequency transpositions are performed in parallel on an input signal (SE) for filtering using respective first and second upstream mixing signals (SM1, SM2) that are substantially in phase quadrature so as to obtain respective first and second transposed signals (ST1, ST2), and the two transposed signals are filtered respectively by two lowpass filters (F1, F2), the frequency of the transposition signals (ω₀) and the passband (B/2) of the lowpass filters being related to the frequency of the input signal (ωₑ) and to the passband desired for the bandpass filter, then respective frequency transpositions are performed on the first and second filtered transposed signals (STF1, STF2) using two respective downstream mixing signals, and the sum or the difference of the two signals obtained in this way is taken, the frequency of the output mixing signals (SMV1, SMV2) is selected to be different from the frequency of the first and second mixing signals so that the output signal is transposed into a desired frequency range, the method being **characterized in that** a common oscillator (LO) is used which is coupled with a first phase shifter (MTM) to produce the upstream mixing signals and which is coupled with a second phase shifter (MTV) to produce the downstream mixing signals, and **in that** the phase shifters are used in opposite manner on the first and second signals so that each of said first and second signals (VT1, VT2) receives the phase-advanced output signal from one of the two phase shifters and the phase-delayed output signal from the other of the two phase shifters.

2. A bandpass filter circuit comprising two parallel processing paths (VT1, VT2) connected between the input (BE) and the output (BS) of the circuit, each path comprising a lowpass filter cell (F1, F2) located between an upstream mixer (MA1, MA2) and a downstream mixer (MV1, MV2), and transposition means (LO, MTM, MTV) delivering two respective upstream mixing signals which are substantially in phase quadrature to the upstream mixers (MA1, MA2), and two respective downstream mixing signals which are substantially phase quadrature to the downstream mixers (MV1, MV2), the circuit further comprising an adder or a subtracter (STM) connected to the outputs from the downstream mixers, transposition means being provided to deliver the downstream mixing signals at a selected frequency (ω₁) different from the frequency of the upstream mixing signals (ω₂) in such a manner that the output signal from the bandpass filter is transposed into a desired frequency range, the circuit being **characterized in that** it comprises a common oscillator (LO) coupled with a first phase shifter (MTM) for producing the upstream mixing signals and coupled with a second phase shifter (MTV) for producing the downstream mixing signals, and **in that** the phase shifters are connected in opposite manner so that each of the two parallel branches (VT1, VT2) receives the phase-advanced output signal from one of the two phase shifters and the phase-delayed output signal from the other of the two phase shifters.

3. A circuit according to claim 2, **characterized in that** the ratio between the frequency of the upstream mixing signals (ω₀) and the frequency of the downstream mixing signals (ω₁) is equal to an integer ratio.

4. A circuit according to claim 2 or claim 3, **characterized in that** the two phase shifters are constituted by circuits each presenting a cutoff frequency between their two phase-shifted outputs that is equal respectively to the frequency of the upstream mixing signals (ω₀) for the first phase shifter (MTM) and to the frequency of the downstream mixing signals (ω₁) for the second phase shifter (MTV).

5. A circuit according to any one of claims 2 to 4, **characterized in that** it comprises an oscillator (LO) coupled to a first phase shifter (MTM) formed by an RC-CR circuit to deliver the upstream mixing signals, and an oscillator (LO) coupled to a second phase shifter (MTV) formed by a second RC-CR circuit to deliver the downstream mixing signals.

6. A circuit according to claim 5, **characterized in that** the capacitors (C, C') of the first and second RC-CR circuits have the same capacitance and the resistors of said circuits are selected so that the ratio (n) of the resistances of the second RC-CR circuit over the resistances of the first RC-CR circuit is equal to the ratio (n) of the frequency of the upstream mixing signals (ω₀) over the frequency of the downstream mixing signals (ω₁).

7. A circuit according to claim 5, **characterized in that** the resistors (R, R') of the first and second RC-CR circuits present the same resistance, and the capacitors (C, C') of said RC-CR circuits are selected so that the ratio (m) of the capacitances of the second RC-CR circuit over the capacitances of the first RC-CR circuit is equal to the ratio (m) of the frequency of the upstream mixing signals (ω₀) over the frequency of the downstream mixing signals (ω₁).

8. A circuit according to claim 5, **characterized in that** the capacitors (C, C') of the first and second RC-CR circuit have capacitances in a ratio equal to an integer ratio, and **in that** the resistors (R, R') of the first and second RC-CR circuits present resistances in a ratio equal to an integer ratio.

9. A circuit according to any one of claims 5 to 8, **characterized in that** the RC-CR circuits are disposed in opposite manner so that each of the two parallel branches (VT1, VT2) receives the phase-advanced output signal from one of the two RC-CR circuits and the phase-delayed output signal from the other of the two RC-CR circuits.

10. A circuit according to any one of claims 2 to 9, in combination with claim 4, **characterized in that** the oscillator (LO) is coupled to one of the first and second phase shifters (MTM, MTV) via at least one frequency transposition means.
